# EUROPEAN PATENT APPLICATION

(11) **EP 4 565 043 A1**
(43) Date of publication of application: **04.06.2025**
(21) Application number: 24216029.9
(22) Date of filing: 28.11.2024
(51) Int. Cl.: H10K 59/12, H10K 77/10

(54) **DISPLAY DEVICE AND METHOD FOR MANUFACTURING THE SAME**

(30) Priority: 29.11.2023 KR 20230169621
(71) Applicant: Samsung Display Co., Ltd., Gyeonggi-Do (KR)
(72) Inventor: LEE, Jeongseok, Yongin-si (KR); KWON, Hyojeong, Yongin-si (KR); KIM, Sooyoun, Yongin-si (KR); OH, Soomin, Yongin-si (KR); HYUN, Jinho, Yongin-si (KR); HWANG, Sangyeon, Yongin-si (KR); YANG, Hee Jun, Yongin-si (KR)
(74) Representative: Marks & Clerk LLP

(57) **Abstract**

A display device includes a display panel including a display region and a non-display region and a coating layer which is disposed directly on a lower surface of the display panel and is a single layer. The coating layer includes a base layer including a resin material and a plurality of fillers dispersed in the base layer, and a surface of the coating layer has an irregular corrugated structure including a curved valley recessed toward the display panel and a curved ridge protruding in a direction being away from the display panel.

## Description

### BACKGROUND

### (1) Field

The disclosure herein relates to a display device and a method for manufacturing the display device, and more particularly, to a display device including a coating layer and a method for manufacturing the display device.

### (2) Description of the Related Art

Various display devices used for multimedia devices such as a television, a mobile phone, a tablet computer, and a game console are being developed. A display device may include various functional layers in order to provide a color image with excellent quality to a user.

Recently, studies are being conducted on a thin display device to achieve various types of display devices such as a display device including a curved surface, a rollable display device, or a foldable display device. A thin display device may be achieved by reducing the number of functional layers and by including a functional layer having various functions.

### SUMMARY

For implementation of a thin display device, it may be desired to secure an impact resistance of the display device. Therefore, studies are being conducted on a structure of a display device having a high impact resistance as well as a small thickness.

The disclosure provides a display device which has improved reliability and impact resistance by disposing, under a display panel, a single coating layer including a surface which has a corrugated structure, and a method for manufacturing the same.

An embodiment of the invention provides a display device including: a display panel including a display region and a non-display region; and a coating layer which is disposed directly on a lower surface of the display panel and is a single layer, where the coating layer includes a base layer including a resin material and a plurality of fillers dispersed in the base layer, and a surface of the coating layer has an irregular corrugated structure including a curved valley recessed toward the display panel and a curved ridge protruding in a direction being away from the display panel.

In an embodiment, a first portion of the coating layer, which is adjacent to the surface may have a first curing rate, and a second portion of the coating layer, which is farther away from the surface than the first portion, may have a second curing rate greater than the first curing rate.

In an embodiment, the coating layer may have an absorbance of about 3.0 or greater.

In an embodiment, the coating layer may have a storage modulus in a range of about 0.01 megapascal (MPa) to about 1 MPa.

In an embodiment, the coating layer may have a thickness in a range of about 50 micrometers (µm) to about 200 µm.

In an embodiment, the coating layer may have a thermal conductivity of about 100 watts per meter-kelvin (W/m·K) or greater.

In an embodiment, the base layer may include a photocurable resin.

In an embodiment, the plurality of fillers may include: a first filler including a light blocking material; and a second filler including a material having a thermal conductivity of about 100 W/m·K or greater.

In an embodiment, the display device may further include a functional layer directly disposed on the surface of the coating layer, having one flat surface, and including a light transmitting resin material.

In an embodiment, the display device may further include a heat dissipation layer disposed on the surface of the coating layer and including a heat dissipation material.

In an embodiment, the display device may further include an electronic module disposed below the coating layer, where the display panel may include a signal transmission region and a non-transmission region adjacent to the signal transmission region, the electronic module may overlap the signal transmission region, and the coating layer may overlap the non-transmission region.

In an embodiment, the display device may further include a window disposed on the display panel and covering the display panel; and a light-blocking pattern disposed on the window and overlapping the non-display region.

In an embodiment of the invention, a method for manufacturing a display device includes providing a display panel including a display region and a non-display region; providing a preliminary coating material on a lower surface of the display panel; and curing the preliminary coating material to form a coating layer which is disposed directly on a lower surface of the display panel, and has, on a surface thereof, an irregular corrugated structure which includes a curved valley recessed toward the display panel and a curved ridge protruding in a direction of being away from the display panel, where in the curing the preliminary coating material to form the coating layer, a surface of the preliminary coating material is exposed to oxygen.

In an embodiment, the preliminary coating material includes: a base resin including a photocurable resin material; and a plurality of fillers dispersed in the base resin.

In an embodiment, in the curing the preliminary coating material to form the coating layer, a concentration of oxygen to which the surface of the preliminary coating material is exposed may be about 50 parts per million (ppm) or greater.

In an embodiment, the curing the preliminary coating material to form the coating layer may include: performing a primary curing on the preliminary coating material to form a first preliminary coating layer having a first curing rate, and a second preliminary coating layer which is more adjacent to the display panel than the first preliminary coating layer and has a second curing rate greater than the first curing rate; and performing a secondary curing on the first preliminary coating layer and the second preliminary coating layer to form the coating layer having, on the surface thereof, the irregular corrugated structure.

In an embodiment, the plurality of fillers may include: a first filler including a light blocking material; and a second filler including a material having a thermal conductivity of about 100 W/m·K or greater.

In an embodiment, a preliminary coating material disposed on the lower surface of the display panel may have a thickness in a range of about 50 µm to about 200 µm.

In an embodiment, the preliminary coating material may be provided to cover an entire portion of the lower surface of the display panel.

In an embodiment, the method may further include forming a functional layer directly disposed on the surface of the coating layer and having one flat surface.

At least some of the above and other features of the invention are set out in the claims.

### BRIEF DESCRIPTION OF THE DRAWINGS

The above and other features of embodiments of the invention will become more apparent by describing in further detail embodiments thereof with reference to the accompanying drawings, in which:
FIG. 1 is a perspective view of a display device according to an embodiment of the invention;
FIG. 2 is an exploded perspective view of a display device according to an embodiment of the invention;
FIG. 3 is a cross-sectional view illustrating a partial configuration of a display device according to an embodiment of the invention;
FIG. 4 is a cross-sectional view of a display panel according to an embodiment of the invention;
FIG. 5 is a cross-sectional view of a display module according to an embodiment of the invention;
FIG. 6 is a plan view of a coating layer according to an embodiment of the invention;
FIG. 7 is a cross-sectional view of a display module according to an embodiment of the invention;
FIG. 8 is a cross-sectional view of a display module according to an embodiment of the invention;
FIGS. 9A to 9E are cross-sectional views illustrating some processes of a method for manufacturing a display device according to an embodiment of the invention; and
FIG. 10 is a cross-sectional view illustrating a process of a method for manufacturing a display device according to an embodiment of the invention.

### DETAILED DESCRIPTION

The invention now will be described more fully hereinafter with reference to the accompanying drawings, in which various embodiments are shown. This invention may, however, be embodied in many different forms, and should not be construed as limited to the embodiments set forth herein. Rather, these embodiments are provided so that this disclosure will be thorough and complete, and will fully convey the scope of the invention to those skilled in the art.

In this specification, it will be understood that when an element (or region, layer, portion, or the like) is referred to as being "on", "connected to" or "coupled to" another element (or region, layer, portion, or the like), it may be directly disposed on, connected to or coupled to another element (or region, layer, portion, or the like), or intervening elements may be disposed therebetween.

Like reference numerals or symbols refer to like elements throughout. Also, in the drawings, the thicknesses, the ratios, and the dimensions of the elements are exaggerated for effective description of the technical contents.

Although the terms first, second, etc., may be used to describe various elements, these elements should not be limited by these terms. These terms are only used to distinguish one element from another element. For example, a first element may be referred to as a second element, and similarly, a second element may also be referred to as a first element without departing from the scope of the invention.

Also, the terms such as "below", "lower", "above", "upper" and the like, may be used for describing a relationship of elements illustrated in the figures. It will be understood that the terms have a relative concept and are described on the basis of the orientation depicted in the figures.

The terminology used herein is for the purpose of describing particular embodiments only and is not intended to be limiting. As used herein, "a", "an," "the," and "at least one" do not denote a limitation of quantity, and are intended to include both the singular expression and plural expression, unless the context clearly indicates otherwise. Thus, reference to "an" element in a claim followed by reference to "the" element is inclusive of one element or a plurality of the elements. For example, "an element" has the same meaning as "at least one element," unless the context clearly indicates otherwise. "At least one" is not to be construed as limiting "a" or "an." "Or" means "and/or." As used herein, the term "and/or" includes any and all combinations of one or more of the associated listed items.

It will be understood that the term "includes" and/or "including" or "comprises" and/or "comprising", when used in this specification, specifies the presence of stated features, integers, steps, operations, elements, components, or a combination thereof, but does not preclude the presence or addition of one or more other features, integers, steps, operations, elements, components, or combinations thereof.

"About" or "approximately" as used herein is inclusive of the stated value and means within an acceptable range of deviation for the particular value as determined by one of ordinary skill in the art, considering the measurement in question and the error associated with measurement of the particular quantity (i.e., the limitations of the measurement system). For example, "about" can mean within one or more standard deviations, or within ± 30%, 20%, 10% or 5% of the stated value.

Unless otherwise defined, all terms (including technical and scientific terms) used herein have the same meaning as commonly understood by one of ordinary skill in the art to which the disclosure belongs. Also, terms, such as those defined in commonly used dictionaries, should be interpreted as having a meaning that is consistent with their meaning in the context of the relevant art and should not be interpreted in an idealized or overly formal sense unless expressly so defined herein.

Embodiments are described herein with reference to cross-sectional views that are schematic illustrations of embodiments. As such, variations from the shapes of the illustrations as a result, for example, of manufacturing techniques and/or tolerances, are to be expected. Thus, embodiments described herein should not be construed as limited to the particular shapes of regions as illustrated herein but are to include deviations in shapes that result, for example, from manufacturing. For example, a region illustrated or described as flat may, typically, have rough and/or nonlinear features. Moreover, sharp angles that are illustrated may be rounded. Thus, the regions illustrated in the figures are schematic in nature and their shapes are not intended to illustrate the precise shape of a region and are not intended to limit the scope of the present claims.

Hereinafter, embodiments of the invention will be described in detail with reference to the accompanying drawings.

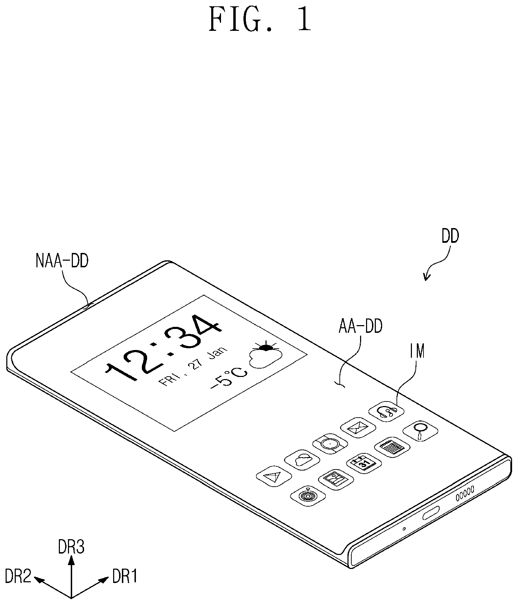

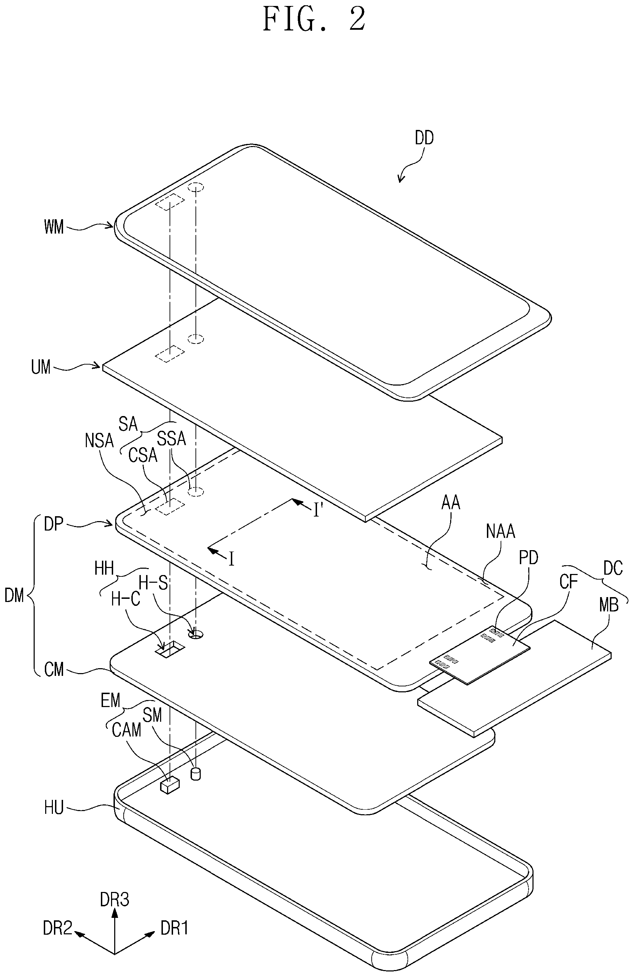

FIG. 1 is a perspective view of a display device DD according to an embodiment of the invention. FIG. 2 is an exploded perspective view of a display device DD according to an embodiment of the invention.

In FIG. 1, an embodiment where the display device DD is implemented as a mobile phone is illustrated as an example. However, the display device DD is not limited thereto, and may be a small- or medium-sized display device such as a tablet computer, a car navigation system, a game console, a wearable device, or a camera.

The display device DD may display an image IM through an active region AA-DD. The active region AA-DD may include a flat surface defined by the first direction DR1 and the second direction DR2. The active region AA-DD may further include a curved surface bent from at least one side of the flat surface on a plane defined by a first direction DR1 and a second direction DR2. FIG. 1 illustrates an embodiment where the display device DD includes two curved surfaces which are respectively bent from both sides of the flat surface defined by the first direction DR1 and the second direction DR2. However, a shape of the active region AA-DD is not limited thereto. In another embodiment, for example, the active region AA-DD may include only the flat surface, or further include at least two curved surfaces, for example, four curved surfaces respectively bent from four side surfaces.

In FIG. 1 and the following drawings, a first direction DR1 to a third direction DR3 are illustrated, and directions indicated by the first to third direction DR1, DR2, and DR3 described herein may have a relative concept and may thus be changed to other directions.

In this specification, the first direction DR1 and the second direction DR2 may be orthogonal to each other, and the third direction DR3 may be a normal direction of a plane defined by the first direction DR1 and the second direction DR2. In this specification, the wording "on a plane" may mean a case when viewed on a plane defined by the first direction DR1 and the second direction DR2, and a thickness direction may mean the third direction DR3 which is a normal direction of a plane defined by the first direction DR1 and the second direction DR2.

In an embodiment, the display device DD may include the active region AA-DD and a peripheral (or non-active) region NAA-DD adj acent to the active region AA-DD. The active region AA-DD may be a portion corresponding to a display region AA of a later-described display panel DP (see FIG. 2), and the peripheral region NAA-DD may be a portion corresponding to a non-display region NAA of the display panel DP (see FIG. 2).

The peripheral region NAA-DD, which is a region for blocking a light signal, may be disposed outside the active region AA-DD and surround the active region AA-DD. In an embodiment, the peripheral region NAA-DD may be disposed not on a front surface but a side surface of the display device DD. In another embodiment, the peripheral region NAA-DD may be omitted.

Referring to FIG. 2, the display device DD according to an embodiment may include a window member WM, a housing HU, a display module DM, a circuit board DC, and an upper member UM.

The display device DD according to an embodiment may include the window member WM disposed on a display panel DP. The window member WM provides or defines an exterior surface of the display device DD. Although not illustrated, the window member WM may include a base substrate and further include functional layers such as an anti-reflection layer, an anti-fingerprint layer, or a phase controlling optical layer.

In the display device DD according to an embodiment, the upper member UM may be disposed below the window member WM and above the display module DM. The upper member UM may include an anti-reflection layer or an input detection sensor. The anti-reflection layer may reduce an external light reflectance. The input detection sensor may detect an external input from a user. The upper member UM may further include an adhesive layer which bonds the anti-reflection layer and the input detection sensor.

In the display device DD according to an embodiment, the display module DM may be disposed below the upper member UM. The display module DM may include the display panel DP and a coating layer CM.

The display panel DP may include a display region AA in which the image IM is displayed and a non-display region NAA adjacent to the display region AA. That is, a front surface of the display panel DP may include the display region AA and the non-display region NAA. The display region AA may be an area activated in response to an electrical signal.

The non-display region NAA may be adjacent to the display region AA. The non-display region NAA may surround the display region AA. In the non-display region NAA, a driving circuit or a driving wire for driving the display region AA, various types of signal lines or pads for providing electrical signals to the display region AA, an electronic element, or the like, may be disposed.

The display region AA may include a signal transmission region SA and a non-transmission region NSA. The signal transmission region SA may overlap an electronic module EM, and the non-transmission region NSA may be disposed to surround at least a portion of the signal transmission region SA. The non-transmission region NSA may correspond to a region other than the signal transmission region SA in the display panel DP.

The signal transmission region SA may overlap an electronic module EM on a plane or when viewed in the third direction DR3. The electronic module EM may receive an external input transmitted through the signal transmission region SA, or provide an output through the signal transmission region SA. The electronic module EM may be disposed below the coating layer CM. The signal transmission region SA may include a camera sensing region CSA and a sensor sensing region SSA. Below the display panel DP, a camera module CAM may be disposed to overlap the camera sensing region CSA, and a sensor module SM may be disposed to overlap the sensor sensing region SSA. Although not illustrated, according to another embodiment, if desired, a predetermined opening may be defined in the signal transmission region SA of the display panel DP. Accordingly, a portion of the display panel DP may be penetrated or define a through hole.

FIG. 2 illustrates an embodiment where the signal transmission region SA includes the camera sensing region CSA and the sensor sensing region SSA, but the number of the signal transmission regions SA is not limited thereto. In an embodiment of the display panel DP, the signal transmission region SA may be defined as a single region or three or more regions. FIG. 2 illustrates an embodiment where the signal transmission region SA has a circular shape or a quadrilateral shape. However, a shape of the signal transmission region SA is not limited thereto, and may be variously defined if desired.

On a plane or when viewed in the third direction DR3, the area of the signal transmission region SA may be smaller than the area of the non-transmission region NSA. The transmittance of the signal transmission region SA may differ from that of the non-transmission region NSA. The transmittance of the signal transmission region SA may be greater than the transmittance of the non-transmission region NSA.

In the display panel DP according to an embodiment, a portion of a driving circuit, a driving wire, or the like for driving pixels (not illustrated) disposed in the signal transmission region SA may be disposed in a portion of the non-display region NAA or the non-transmission region NSA. Accordingly, the wiring density in the signal transmission region SA may be less than the wiring density in the non-transmission region NSA. However, an embodiment of the invention is not limited thereto, and the wiring density in the signal transmission region SA may be substantially the same as the wiring density in the non-transmission region NSA.

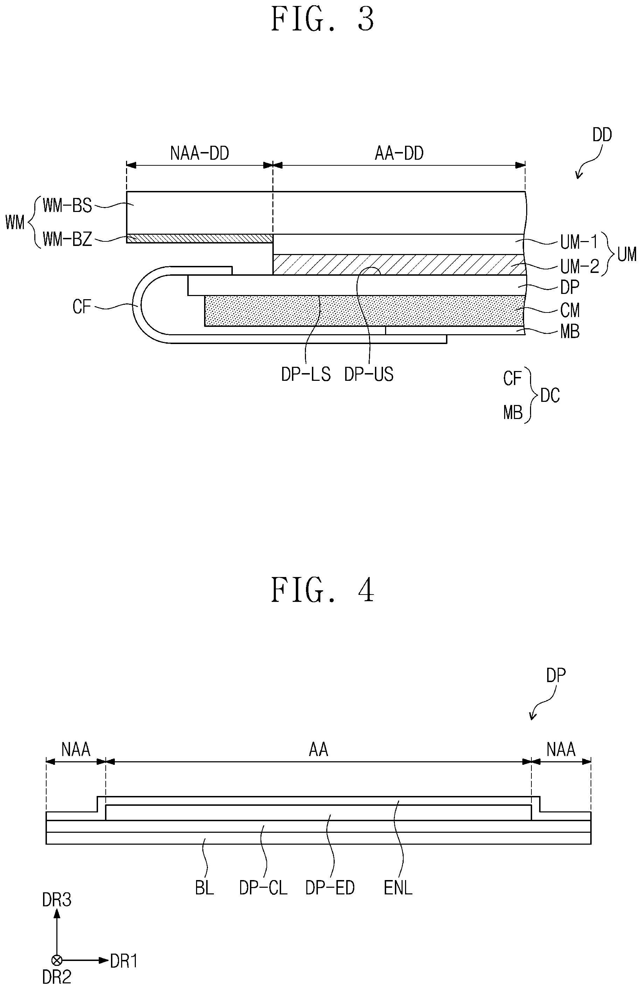

The display panel DP may include a light-emitting element layer DP-ED (see FIG. 4) including an organic light-emitting element, a quantum dot light-emitting element, a micro light emitting diode (LED) light-emitting element, or a nano LED light-emitting element, and the like. The light-emitting element layer DP-ED (see FIG. 4) may be configured to substantially generate light for displaying images.

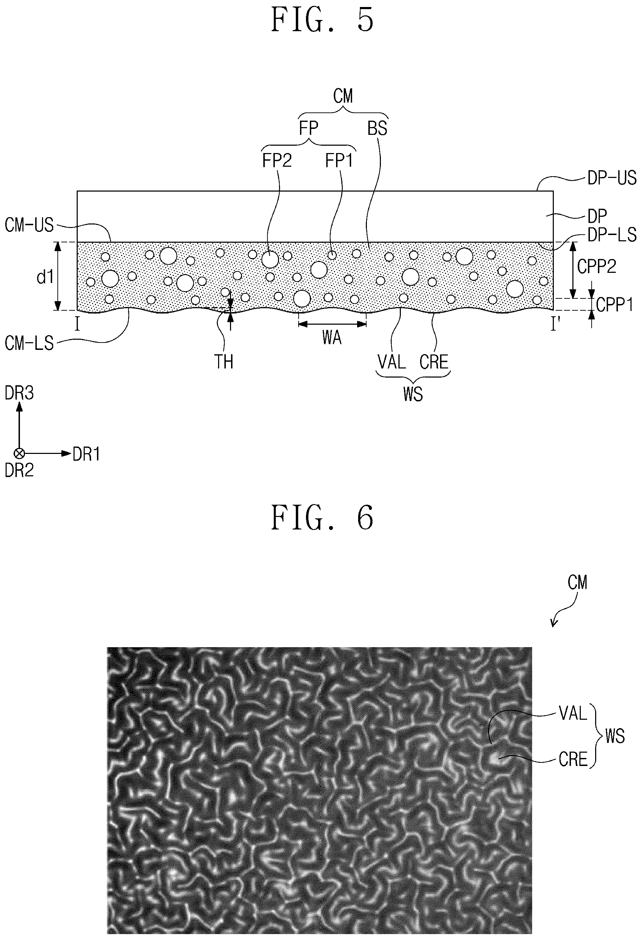

The coating layer CM may be disposed under the display panel DP. The coating layer CM may be a multi-functional member or unit which supports the display panel DP to enhance impact resistance, performs a heat dissipation function of dissipating heat generated in the display panel DP, and performs a light blocking function of blocking light. A hole HH may be defined in the coating layer CM. The hole HH may be defined in a region corresponding to the electronic module EM in the coating layer CM. The hole HH may be defined in the coating layer CM to overlap the signal transmission region SA in the third direction DR3, which is a thickness direction thereof. In an embodiment, the hole HH of the coating layer CM may be defined as a single hole or a plurality of holes. The hole HH may include a sensor hole H-S and a camera hole H-C. The sensor hole H-S may correspond to the sensor sensing region SSA described above, and the camera hole H-C may correspond to the camera sensing region CSA described above. That is, below the coating layer CM, the sensor module SM may be disposed to overlap the sensor hole H-S, and the camera module CAM may be disposed to overlap the camera hole H-C. The details of the coating layer CM will be described later with reference to FIG. 5.

The display device DD may include the circuit board DC connected to the display panel DP. The circuit board DC may include a flexible board CF and a main board MB. The flexible board CF may include an insulating film and conductive wires mounted on the insulating film. The conductive wires are connected to the pads PD to electrically connect the circuit board DC to the display panel DP. In another embodiment, the flexible board CF may be omitted, and the main board MB may be directly connected to the display panel DP.

The main board MB may include signal lines and electronic elements which are not illustrated. The electronic elements may be connected to the signal lines to be electrically connected to the display panel DP. The electronic elements generate various types of electrical signals, for example, signals for generating images IM or signals for detecting external inputs, or process detected signals. In an embodiment, the main board MB may be provided in plurality to correspond to each of electrical signals for generation and processing, and is not limited to any one embodiment.

In the display device DD according to an embodiment, an electronic module EM may be an electronic component which outputs or receives a light signal. In an embodiment, for example, the electronic module EM may include a camera module CAM and a sensor module SM. The camera module CAM may receive external light through the camera sensing region CSA and capture an external image. Also, the sensor module SM may be a sensor such as a proximity sensor or infrared light-emitting sensor which outputs or receives external light through the sensor sensing region SSA.

The display device DD according to an embodiment may include a housing HU disposed below the coating layer CM. The display panel DP, etc., may be accommodated inside the housing HU. In the display device DD according to an embodiment, the window member WM and the housing HU may be coupled to each other to constitute the exterior of the display device DD.

FIG. 3 is a cross-sectional view illustrating a partial configuration of a display device DD according to an embodiment of the invention.

Referring to FIG. 3, the display device DD according to an embodiment of the invention may include a window member WM, an upper member UM, a display panel DP, a circuit board DC, and a coating layer CM.

In an embodiment, the window member WM may cover a front surface of the display panel DP. The window member WM may comprise a window WM-BS and a light-blocking pattern WM-BZ. The window WM-BS may be disposed on the display panel DP and cover the display panel DP. The window WM-BS may include a first base layer, which is transparent, such as a glass substrate or a transparent film. The light-blocking pattern WM-BZ may be disposed on the window WM-BS and overlap the peripheral region NAA-DD. The light-blocking pattern WM-BZ may have a multi-layered structure. The multi-layered structure of the light-blocking pattern WM-BZ may include a colored color layer and a black light blocking layer. The colored color layer and black light blocking layer may be formed through deposition, printing, or coating processes. In an embodiment, the light-blocking pattern WM-BZ may be omitted from the window member WM, and may also be formed not on the window WM-BS but on the upper member UM.

In an embodiment, the upper member UM may include an anti-reflection layer UM-1 and an input sensor UM-2. The upper member UM may be disposed on an upper surface DP-US of the display panel DP.

The anti-reflection layer UM-1 may reduce an external light reflectance. The anti-reflection layer UM-1 may include a retarder and/or a polarizer. The anti-reflection layer UM-1 may include a polarizing film or color filters. The color filters may have a predetermined arrangement. The arrangement of the color filters may be determined in consideration of colors of light emitted from pixels included in the display panel DP. The anti-reflection layer UM-1 may include a division layer adjacent to the color filters.

The input sensor UM-2 may include a plurality of sensing electrodes (not illustrated) for detecting an external input, trace lines (not illustrated) connected to the plurality of sensing electrodes, and an inorganic layer and/or an organic layer for insulating/protecting the plurality of sensing electrodes or trace lines. The input sensor UM-2 may be a capacitive sensor, but is not particularly limited thereto.

In an embodiment, the input sensor UM-2 may be formed directly on a later-described encapsulation layer ENL of FIG. 4 (see FIG. 4) through a continuous process during the manufacturing of the display panel DP. However, an embodiment of the invention is not limited thereto. The input sensor UM-2 may be manufactured as a panel separately from the display panel DP and then attached to the display panel DP through an adhesive layer.

In an embodiment, an adhesive layer (not shown) may be further disposed between the window member WM and the anti-reflection layer UM-1, and an adhesive layer may be further disposed between the anti-reflection layer UM-1 and the input sensor UM-2. The window, the anti-reflection layer UM-1, and the input sensor UM-2 may be respectively boned to each other through adhesive layers.

In an embodiment, the circuit board DC may include a flexible board CF and a main board MB. In an embodiment, the flexible board CF may be assembled in a bent state. Accordingly, the main board MB may be disposed on a rear surface of the display panel DP and may be stably accommodated within a space provided by the housing HU (see FIG. 2). In an embodiment, for example, the flexible board CF may be bent toward a rear surface of the display panel DP and may be disposed below a lower member LM. However, an embodiment of the invention is not limited thereto, and in another embodiment, the flexible board CF may be omitted. In such an embodiment, the main board MB may be disposed directly on a lower side of the coating layer CM or mounted within the coating layer CM.

In an embodiment, the coating layer CM is disposed under the display panel DP. The coating layer CM may be disposed directly on a lower surface DP-LS of the display panel DP and in contact with the lower surface DP-LS of the display panel DP. The coating layer CM may be in contact with the circuit board DC. In an embodiment, for example, the coating layer CM may be in contact with the main board MB. The details of the coating layer CM will be described below with reference to FIG. 5.

FIG. 4 is a cross-sectional view of a display panel DP according to an embodiment.

In an embodiment, the display panel DP includes a base substrate BL, a display circuit layer DP-CL disposed on the base substrate BL, a light-emitting element layer DP-ED, and an encapsulation layer ENL. The base substrate BL may include a plastic substrate, a glass substrate, a metal substrate, an organic/inorganic composite material substrate, or the like. In an embodiment, for example, the base substrate BL may include at least one polyimide layer.

The display circuit layer DP-CL includes at least one insulating layer, semiconductor patterns, and conductive patterns. The insulating layer includes at least one inorganic layer and at least one organic layer. The semiconductor patterns and the conductive patterns may form or define signal lines, a pixel driving circuit, and a scan driving circuit. Additionally, the display circuit layer DP-CL may include a rear surface metal layer.

The light-emitting element layer DP-ED includes a display element, for example, a light-emitting element. In an embodiment, for example, the light-emitting element may be an organic light-emitting element, a quantum dot light-emitting element, a micro-LED light-emitting element, or a nano-LED light-emitting element. The light-emitting element layer DP-ED may further include an organic layer such as a pixel-defining film.

The light-emitting element layer DP-ED may be disposed in a display region AA. A non-display region NAA is disposed in outer peripheries of the display region AA and surrounds the display region AA. A light-emitting element may not be arranged in the non-display region NAA.

An encapsulation layer ENL may be disposed on the light-emitting element layer DP-ED and cover the light-emitting element layer DP-ED. The encapsulation layer ENL may be disposed on the display circuit layer DP-CL to seal the light-emitting element layer DP-ED. The encapsulation layer ENL may be a thin-film encapsulation layer including a plurality of inorganic thin films and organic thin films. The encapsulation layer ENL may include a thin-film encapsulation layer having a stacked structure of an inorganic layer/an organic layer/an inorganic layer. A stacked structure of the encapsulation layer ENL is not particularly limited.

FIG. 5 is a cross-sectional view of a display module DM (see FIG. 2) according to an embodiment of the invention.

Referring to FIG. 5, the display module DM (see FIG. 2) according to an embodiment of the invention may include a display panel DP and a coating layer CM disposed under the display panel DP. The display module DM may be composed of the display panel DP and the coating layer CM.

In an embodiment, the coating layer CM may be directly disposed on a lower surface DP-LS of the display panel DP, i.e., a lower surface of the base substrate BL (see FIG. 4) of the display panel DP. An upper surface CM-US of the coating layer CM may be in direct contact with the lower surface DP-LS of the display panel DP. In the display device DD (see FIG. 1) according to an embodiment of the invention, only the coating layer CM may be disposed under the display panel DP. That is, the lowermost surface of the display module DM may be defined as a lower surface CM-LS of the coating layer CM. Accordingly, a thickness of the display device DD (see FIG. 1) according to an embodiment may be reduced and components may be simplified, thereby increasing process efficiency during the manufacturing of the display device DD (see FIG. 1) according to an embodiment.

The coating layer CM includes a base layer BS including a resin material and a plurality of fillers FP dispersed in the base layer BS. The coating layer CM may be a single layer composed of or defined by the base layer BS and the plurality of fillers FP. The plurality of fillers FP may be fillers dispersed in the base layer BS.

The coating layer CM includes the base layer BS and the plurality of fillers FP, and may thus perform multiple functions within the display device DD (see FIG. 1). For example, the coating layer CM may support the display panel DP and disperse an impact applied to the display panel DP, thereby improving impact resistance. The coating layer CM may protect the display panel DP, etc., against a physical impact applied from the outside of the display device DD (see FIG. 1). The coating layer CM may perform a heat dissipation function of dissipating heat generated from an element adjacent thereto, e.g., the display panel DP, or the like. The coating layer CM may include a light blocking material to perform a light blocking function. The coating layer CM may also have an electromagnetic shielding function, or the like. In such an embodiment, the coating layer CM, which is a single layer, performs functions which are conventionally performed by a plurality of typical functional layers, thereby making it possible to simplify a structure of a display device and achieve a thickness reduction. However, the function of the coating layer CM is not limited thereto, and the coating layer CM may additionally perform other functions within the display device DD according to characteristics of the coating layer CM, such as a thickness and material thereof.

The base layer BS may be a layer which provides a base material in which the plurality of fillers FP are dispersed. The base layer BS may include an organic material. The base layer BS may include at least one selected from an acrylate-based polymer, a urethane-based polymer, a silicone-based polymer, and an imide-based polymer. The base layer BS may include a curable resin material. In an embodiment, for example, the base layer BS may include a photocurable resin material. The base layer BS may include a material having a predetermined strength.

The plurality of fillers FP may each include an organic material or an inorganic material. In an embodiment, for example, the plurality of fillers FP may each include graphite or metal particles. The plurality of fillers FP may include a same material as each other or different materials from each other. The plurality of fillers FP may be fillers which perform a same function as each other or respectively perform different functions from each other. Accordingly, the coating layer CM may perform multiple functions such as supporting of the display panel DP, heat dissipating, light blocking, and shielding of the display device DD (see FIG. 1).

The plurality of fillers FP may each include a light transmitting material. In an embodiment where the base layer BS includes a photocurable resin material and the filler FP includes a light transmitting material, the coating layer CM may be manufactured by photocuring method.

The plurality of fillers FP may include a first filler FP1 including a light blocking material and a second filler FP2 including a material having a thermal conductivity of about 100 watts per meter-kelvin (W/m K) or greater. The first filler FP1 may be a black pigment. The first filler FP1 prohibits light heading toward the coating layer CM from being transmitted through the coating layer CM, and thus the coating layer CM may perform a light blocking function. The second filler FP2 includes a material with high thermal conductivity, and thus the coating layer CM may perform a heat dissipation function. The second filler FP2 may include metal particles with high thermal conductivity, carbon nano tubes (CNT), or graphene. The coating layer CM may perform the light blocking and heat dissipation functions due to the first filler FP1 and the second filler FP2. Accordingly, in such an embodiment, an additional light blocking layer or heat dissipation layer may be omitted.

The coating layer CM may have an absorbance of about 3.0 or greater. Since the coating layer CM has an absorbance of about 3.0 or greater, light heading toward the coating layer CM may not be transmitted through the coating layer CM. In a case where the coating layer CM has an absorbance of less than about 3.0, the coating layer CM may not serve as a light blocking layer. An absorbance may mean an absorbance in the ultraviolet-visible (UV-Vis) range. However, a meaning of the absorbance is not limited thereto.

The coating layer CM may have a thermal conductivity of about 100 W/m·K or greater. Since the coating layer CM may have a thermal conductivity of about 100 W/m K or greater, the coating layer CM may function as a heat dissipation layer. Accordingly, in such an embodiment, an additional heat dissipation layer may be omitted, and thus a thickness of the display module DM may be reduced. A thermal conductivity may be the value measured at about 25°C. However, condition of the measurement is not limited thereto.

The coating layer CM may have a storage modulus in a range of about 0.01 megapascal (MPa) to about 1 MPa. The value of the storage modulus of the coating layer CM may be less than that of a typical or conventional support layer provided in a display device DD (see FIG. 1) to support a display panel. Accordingly, the coating layer CM may be designed to be more flexible than a typical or conventional support layer, and thus stress applied to the display panel DP during folding or rolling of a display device DD (see FIG. 1) may be reduced. In a case where the coating layer CM has a storage modulus of less than about 0.01 MPa, the coating layer CM may not effectively support the display panel DP. In a case where the coating layer CM has a storage modulus of greater than about 1 MPa, a flexibility of the coating layer CM may decrease, and thus the stress applied to the display panel DP during folding or rolling of the display device DD (see FIG. 1) may increase. A storage modulus may be the value measured at temperatures ranging from -50°C to 300°C and at frequencies of 1 Hz, 10 Hz, or 100 Hz. However, condition of the measurement is not limited thereto.

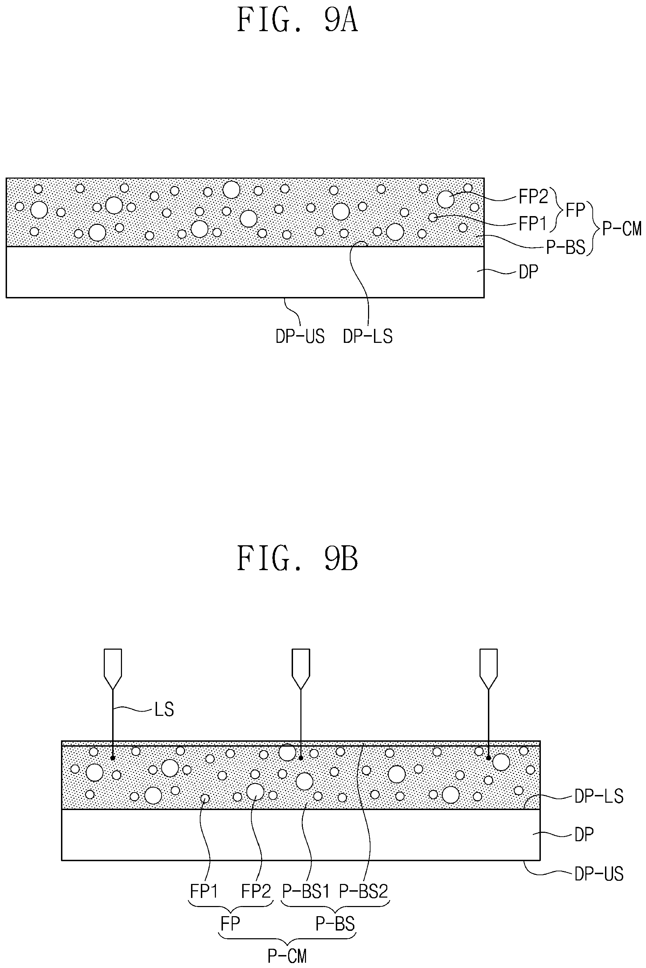

The coating layer CM may have a thickness d1 in a range of about 50 micrometers (µm) to about 200 µm. In a case where the coating layer CM has a thickness d1 of less than about 50 µm, a corrugated structure WS may not be properly formed on a lower surface CM-LS of the coating layer CM. This is because the corrugated structure WS of the coating layer CM is formed due to a difference in a curing rate and a shrinkage rate between a surface portion and a deep portion. The details thereof will be described later in a method for manufacturing a display device DD (see FIG. 1) described with reference to FIGS. 9A to 9E.

In a case where the coating layer CM has a thickness d1 of greater than about 200 µm, the thickness of the display module DM may become excessively great. In this case, a thickness of a display device DD (see FIG. 1) may not be substantially reduced by replacing a plurality of functional layers with a single coating layer CM. Additionally, in this case, as the coating layer CM becomes excessively thicker, stress applied to the display panel DP during the rolling and folding of the display device DD (see FIG. 1) may increase.

The lower surface (or surface) CM-LS of the coating layer CM may include an irregular corrugated structure WS including a wave (or curved) valley (i.e., a curvedly concave surface portion) VAL and a wave (or curved) ridge (i.e., a curvedly convex surface portion) CRE. Due to the corrugated structure WS of the lower surface CM-LS of the coating layer CM, an external impact applied in a direction perpendicular to the coating layer CM may be dispersed in a horizontal direction. That is, when an impact is applied to the corrugated structure WS in a vertical direction, micro-deformation of the corrugated structure WS may reduce an amount of impact, and thus impact resistance may be greatly improved.

The wave valley VAL may have a shape recessed toward the display panel DP. The wave ridge CRE may have a shape protruding in a direction being away from the display panel DP. In the corrugated structure WS, the wave valley VAL and the wave ridge CRE may be alternately disposed and extend in the horizontal direction.

The corrugated structure WS may have a specific thickness TH and a wavelength WA. In this case, the thickness TH may mean a height difference between the wave valley VAL and the wave ridge CRE, that is, a thickness difference between a thickest portion and a thinnest portion of the coating layer CM. In this case, the wavelength WA may be a distance between the highest points of the adjacent wave ridges CRE. The corrugated structure WS may have an atypical shape on a plane while having a predetermined thickness TH and a wavelength WA. The thickness TH and the wavelength WA of the corrugated structure WS may vary according to a thickness of the coating layer CM and a concentration of oxygen exposed during the curing of the coating layer CM.

The coating layer CM may include a first portion CPP1 adjacent to the lower surface CM-LS and a second portion CPP2 farther away from the lower surface CM-LS than the first portion CPP1. The first portion CPP1 may have a first curing rate, and the second portion CPP2 may have a second curing rate greater than the first curing rate. This is because a portion adjacent to a surface is not properly cured due to oxygen to which the surface is exposed during the curing of the coating layer CM. Due to a difference in curing rates, the corrugated structure WS may be formed on the lower surface CM-LS of the coating layer CM. The details thereof will be described later in a method for manufacturing a display device DD (see FIG. 1) described with reference to FIGS. 9A to 9E.

FIG. 6 is a plan view of a coating layer CM according to an embodiment of the invention. More specifically, FIG. 6 is a plan view of a lower surface CM-LS (see FIG. 5) of a coating layer CM when viewed on a plane.

Referring to FIGS. 5 and 6, the lower surface CM-LS of the coating layer CM may have a structure in which the wave ridge CRE protruding in a direction being away from the display panel DP and the wave valley VAL recessed toward the display panel DP are repeatedly disposed. However, shapes of the wave ridge CRE and the wave valley VAL may form an irregular and atypical corrugated structure WS with no specific rule.

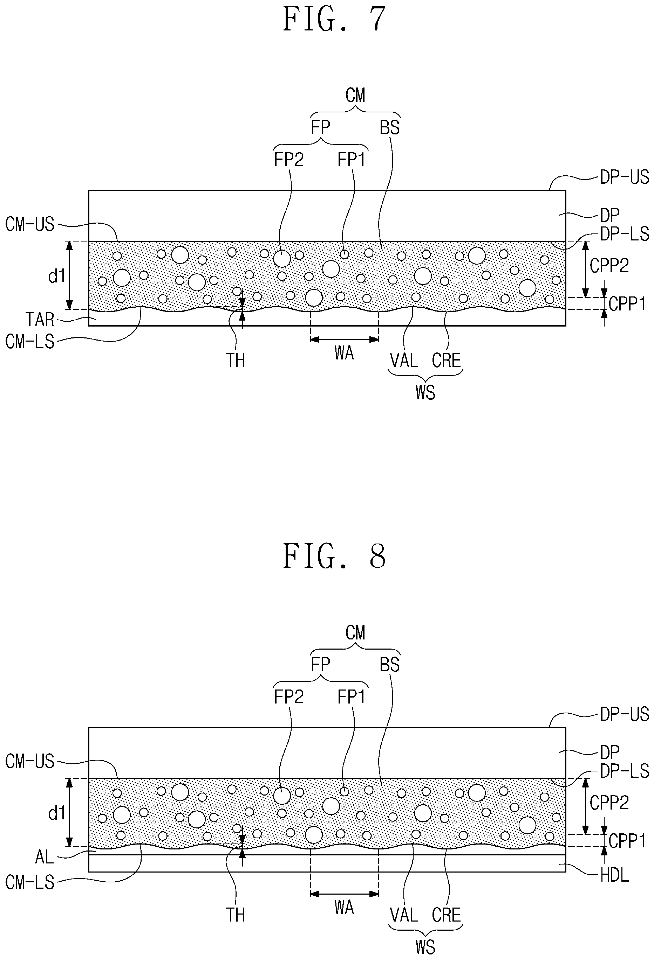

FIG. 7 is a cross-sectional view of a display module DM (see FIG. 2) according to an embodiment of the invention. Hereinafter, the same reference numerals or symbols are used for the same or like components as those described with reference to FIG. 6, and any repetitive detailed description thereof will be omitted.

Referring to FIG. 7, in an embodiment, a display module DM (see FIG. 2) may further include a functional layer TAR including one flat surface. The functional layer TAR may further include a resin material. The functional layer TAR may be in direct contact with the lower surface CM-LS of the coating layer CM. The functional layer TAR may be formed by applying the resin material to the lower surface CM-LS of the coating layer CM.

The functional layer TAR may have one flat surface provided on the corrugated structure WS of the coating layer CM. Since the corrugated structure WS is planarized by the functional layer TAR, an impact applied to the coating layer CM is further alleviated, and thus impact resistance may be improved. The functional layer TAR may include a light transmitting material. The functional layer TAR may include a transparent resin material. The refractive index of the functional layer TAR is matched with or substantially the same as the refractive index of the corrugated structure WS, and thus the corrugated structure WS may be effectively prevented from being viewed from the outside.

FIG. 8 is a cross-sectional view of a display module DM (see FIG. 2) according to an embodiment of the invention. Hereinafter, the same reference numerals or symbols are used for the same or like components as those described with reference to FIG. 6, and any repetitive detailed description thereof will be omitted.

Referring to FIG. 8, in an embodiment, a display module DM may further include an adhesive layer AL and a heat dissipation layer HDL. The heat dissipation layer HDL may be disposed on a lower surface CM-LS of a coating layer CM and include a heat dissipation material. The heat dissipation layer HDL may further strengthen a heat dissipation function of the coating layer CM. A metal with high thermal conductivity, etc., may be used as or included in the heat dissipation layer HDL. In an embodiment, for example, the heat dissipation layer HDL may be a copper layer. However, the heat dissipation layer HDL is not limited thereto, and various materials may be used as needed.

Although not illustrated in FIG. 8, in an embodiment where the display module DM further includes the heat dissipation layer HDL, a second filler FP2 which performs a heat dissipating function may be omitted from the coating layer CM. The heat dissipation layer HDL may be bonded to the lower surface CM-LS of the coating layer CM via the adhesive layer AL.

FIGS. 9A to 9E are cross-sectional views illustrating some processes of a method for manufacturing a display device DD (see FIG. 1) according to an embodiment of the invention. Hereinafter, the same reference numerals or symbols are used for the same or like components as those described with reference to FIGS. 1 to 8, and any repetitive detailed description thereof will be omitted.

Referring to FIG. 9A, in a method for manufacturing a display device DD (see FIG. 1) according to an embodiment of the invention, a display panel DP may be provided or prepared and then a preliminary coating material P-CM may be provided or formed on a lower surface DP-LS of the display panel DP. The preliminary coating material P-CM may include a base resin P-BS including a photocurable resin material and a plurality of fillers FP which are dispersed in the base resin P-BS. The plurality of fillers FP may include a first filler FP1 which includes a light blocking material and performs a light blocking function, and a second filler FP2 which includes a material having a thermal conductivity of about 100 W/m K and performs a heat dissipation function. The preliminary coating material P-CM may be entirely provided on (or provided to cover an entire portion of) the lower surface DP-LS of the display panel DP.

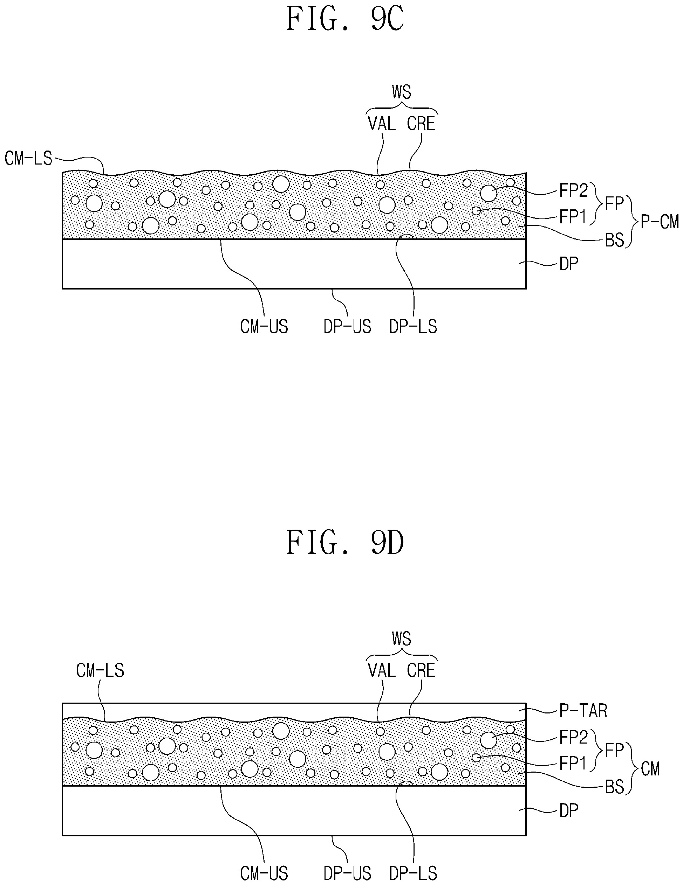

The preliminary coating material P-CM may have a thickness in a range of about 50 µm to about 200 µm. If the preliminary coating material P-CM has a thickness of less than about 50 µm, a corrugated structure WS (see FIG. 9C) of a coating layer CM (see FIG. 9C) may not be formed. If the preliminary coating material P-CM has a thickness of greater than about 200 µm, the thickness of the display module DM may become excessively great.

Referring to FIG. 9B, the preliminary coating material P-CM may be cured to form a first preliminary coating layer P-BS2 having a first curing rate, and a second preliminary coating layer P-BS1 which is more adjacent to the display panel DP than the first preliminary coating layer P-BS2 and has a second curing rate greater than the first curing rate (primary curing process).

In the primary curing process, the preliminary coating material P-CM may be irradiated with light LS. The light LS may be ultraviolet rays. In this process, a surface of the preliminary coating material P-CM may be exposed to oxygen. A concentration of oxygen may be about 50 parts per million (ppm) or greater. The curing may be performed more slowly in a case where the surface of the preliminary coating material P-CM is exposed to oxygen than in a case where the curing is performed in the absence of oxygen even when irradiated with the light LS. A portion, which is adjacent to a surface of the preliminary coating material P-CM and is in contact with oxygen more actively than a core portion of the preliminary coating material P-CM is, may be cured slowly. The curing rate of the second preliminary coating layer P-BS1 farther away from the surface of the preliminary coating material P-CM may be higher than the curing rate of the first preliminary coating layer P-BS2 adjacent to the surface of the preliminary coating material P-CM.

A difference in curing rate between the first preliminary coating layer P-BS2 and the second preliminary coating layer P-BS1 may result in a difference in shrinkage rate between the first preliminary coating layer P-BS2 and the second preliminary coating layer P-BS1, and thus the surface CM-LS (see FIG. 9C) of the coating layer CM (see FIG. 9C) may have the corrugated structure WS (see FIG. 9C). That is, the shrinkage rate of the more cured second preliminary coating layer P-BS 1 may be greater than the shrinkage rate of the less cured first preliminary coating layer P-BS2, and thus the difference in shrinkage rate between the first preliminary coating layer P-BS2 and the second preliminary coating layer P-BS1 may form the corrugated structure WS (see FIG. 9C) on the surface of the coating layer CM (see FIG. 9C).

As a thickness of the preliminary coating material P-CM increases, a difference in curing rate between a surface portion and a deep portion of the preliminary coating material P-CM increases, and thus a largely corrugated structure WS may be formed. Additionally, only when the concentration of oxygen to which the surface of the preliminary coating material P-CM is exposed is about 50 ppm or greater, the difference in curing rate between the surface portion and the deep portion of the preliminary coating material P-CM may be caused. A shape of the corrugated structure WS may be adjusted by controlling the thickness of the preliminary coating material P-CM and the concentration of oxygen to which the surface of the preliminary coating material P-CM is exposed.

Referring to FIGS. 9B and 9C, the first preliminary coating layer P-BS2 and the second preliminary coating layer P-BS1 may be cured to form the coating layer CM including, on the surface CM-LS, the irregular corrugated structure WS (secondary curing process). The coating layer CM may be disposed directly on the lower surface DP-LS of the display panel DP, and may have, on the surface CM-LS thereof, the irregular corrugated structure WS which includes a wave valley VAL recessed toward the display panel DP and a wave ridge CRE protruding in a direction being away from the display panel DP. During the curing, the surface of the preliminary coating material P-CM may be exposed to oxygen. Only when the concentration of oxygen, to which the surface of the preliminary coating material P-CM is exposed, is about 50 ppm or greater, the irregular corrugated structure WS may be formed on the surface CM-LS of the coating layer CM.

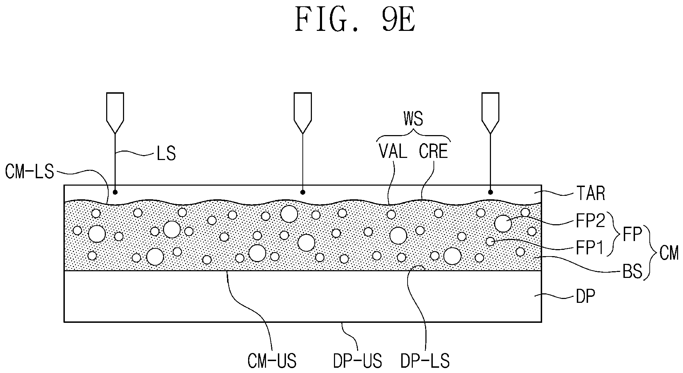

Referring to FIGS. 9D and 9E, a preliminary functional layer P-TAR including a resin material may be further applied on the surface CM-LS of the coating layer CM. The applied preliminary functional layer P-TAR may be cured by irradiation with the light LS, and then the functional layer TAR may be formed. The functional layer TAR may be directly disposed on the surface CM-LS of the coating layer CM, and include one flat surface. The functional layer TAR may include a light transmitting resin material.

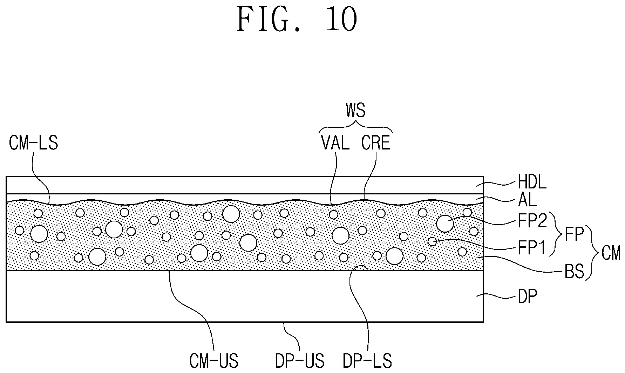

FIG. 10 is a cross-sectional view illustrating a process of a method for manufacturing a display device according to an embodiment of the invention.

Referring to FIG. 10, in an embodiment, a heat dissipation layer HDL may be formed on a surface CM-LS of a coating layer CM. An adhesive layer AL may be formed on the surface CM-LS of the coating layer CM, and the heat dissipation layer HDL including a heat dissipation material may be formed on the adhesive layer AL.

The invention should not be construed as being limited to the embodiments set forth herein. Rather, these embodiments are provided so that this disclosure will be thorough and complete and will fully convey the concept of the invention to those skilled in the art.

While the invention has been particularly shown and described with reference to embodiments thereof, it will be understood by those of ordinary skill in the art that various changes in form and details may be made therein without departing from the scope of the invention as defined by the following claims.

## Claims

1. A display device comprising:
a display panel including a display region and a non-display region; and
a coating layer which is disposed directly on a lower surface of the display panel and is a single layer,
wherein the coating layer includes a base layer including a resin material and a plurality of fillers dispersed in the base layer, and
a surface of the coating layer has an irregular corrugated structure including a curved valley recessed toward the display panel and a curved ridge protruding in a direction being away from the display panel.

2. The display device of claim 1, wherein a first portion of the coating layer, which is adjacent to the surface, has a first curing rate, and
a second portion of the coating layer, which is farther away from the surface than the first portion, has a second curing rate greater than the first curing rate.

3. The display device of claim 1 or claim 2, wherein the coating layer has an absorbance of about 3.0 or greater.

4. The display device of any one of claims 1 to 3, wherein the coating layer has a storage modulus in a range of about 0.01 MPa to about 1 MPa.

5. The display device of any one of claims 1 to 4, wherein the coating layer has a thickness in a range of about 50 µm to about 200 µm.

6. The display device of any one of claims 1 to 5, wherein the coating layer has a thermal conductivity of about 100 W/m K or greater.

7. The display device of any one of claims 1 to 6, wherein the base layer comprises a photocurable resin.

8. The display device of any one of claims 1 to 7, wherein the plurality of fillers comprise:
a first filler including a light blocking material; and
a second filler including a material having a thermal conductivity of about 100 W/m·K or greater.

9. The display device of any one of claims 1 to 8, further comprising:
(i) a functional layer directly disposed on the surface of the coating layer, having one flat surface, and including a light transmitting resin material; or
(ii) a heat dissipation layer disposed on the surface of the coating layer and including a heat dissipation material.

10. The display device of any one of claims 1 to 9, further comprising:
(i) an electronic module disposed below the coating layer,
wherein the display panel includes a signal transmission region and a non-transmission region adjacent to the signal transmission region,
the electronic module overlaps the signal transmission region, and
the coating layer overlaps the non-transmission region; and/or
(ii) a window disposed on the display panel and covering the display panel; and
a light-blocking pattern disposed on the window and overlapping the non-display region.

11. A method for manufacturing a display device, the method comprising:
preparing a display panel including a display region and a non-display region;
providing a preliminary coating material on a lower surface of the display panel; and
curing the preliminary coating material to form a coating layer which is disposed directly on the lower surface of the display panel, and has, on a surface thereof, an irregular corrugated structure which includes a curved valley recessed toward the display panel and a curved ridge protruding in a direction being away from the display panel,
wherein in the curing the preliminary coating material to form the coating layer, a surface of the preliminary coating material is exposed to oxygen.

12. The method of claim 11, wherein the preliminary coating material comprises:
a base resin including a photocurable resin material; and
a plurality of fillers dispersed in the base resin.

13. The method of claim 11 or claim 12, wherein:
(i) in the curing the preliminary coating material to form the coating layer, a concentration of the oxygen, to which the surface of the preliminary coating material is exposed, is about 50 ppm or greater; and/or
(ii) the curing the preliminary coating material to form the coating layer comprises:
performing a primary curing on the preliminary coating material to form a first preliminary coating layer having a first curing rate, and a second preliminary coating layer which is more adjacent to the display panel than the first preliminary coating layer and has a second curing rate greater than the first curing rate; and
performing a secondary curing on the first preliminary coating layer and the second preliminary coating layer to form the coating layer having, on the surface thereof, the irregular corrugated structure.

14. The method of claim 12 or claim 13, wherein the plurality of fillers comprise:
a first filler including a light blocking material; and
a second filler including a material having a thermal conductivity of about 100 W/m·K or greater.

15. The method of any one of claims 11 to 14, wherein:
(i) the preliminary coating material disposed on the lower surface of the display panel has a thickness in a range of about 50 µm to about 200 µm; and/or
(ii) the preliminary coating material is provided to cover an entire portion of the lower surface of the display panel; and/or
(iii) the method further comprises forming a functional layer directly on the surface of the coating layer and having one flat surface.
